# EUROPEAN PATENT APPLICATION

(11) **EP 4 586 363 A1**
(43) Date of publication of application: **16.07.2025**
(21) Application number: 24219471.0
(22) Date of filing: 12.12.2024
(51) Int. Cl.: H01M 10/42, H01M 50/204, H01M 50/284, H05K 1/00

(54) **RECHARGEABLE BATTERY MODULE**

(30) Priority: 12.01.2024 KR 20240005664
(71) Applicant: Samsung SDI Co., Ltd., Gyeonggi-do 17084 (KR)
(72) Inventor: Ahn, Jaepil, Yongin-si, Gyeonggi-do 17084 (KR); Yun, Chuljung, Yongin-si, Gyeonggi-do 17084 (KR)
(74) Representative: Gulde & Partner

(57) **Abstract**

A rechargeable battery module is provided. The rechargeable battery module includes a busbar holder for covering battery cells, a busbar in the busbar holder for electrically connecting the battery cells, a flexible printed circuit in the busbar holder for transmitting a detection signal of a temperature or a voltage of one of the battery cells, a battery management system for receiving a transmission signal from a wireless communicator connected to the flexible printed circuit, and a printed circuit board on the flexible printed circuit for accommodating a circuit element on the flexible printed circuit for the wireless communicator.

## Description

### BACKGROUND

### 1. Field

The present disclosure relates to a rechargeable battery module.

### 2. Description of the Related Art

Unlike a primary battery, a rechargeable battery is a battery that performs charging and discharging repeatedly. Small-capacity rechargeable batteries are used in small and portable electronic devices such as mobile phones, laptop computers, and camcorders.

Rechargeable batteries with large capacity and high density are used as power for driving motors in hybrid vehicles and electric vehicles or for energy storage. The rechargeable battery may be used by forming a rechargeable battery module containing a plurality of battery cells in series and/or coupled in parallel to drive the motor of a hybrid vehicle, for example, which may suitably use relatively high energy density.

The rechargeable battery module detects a temperature and a voltage of a battery cell through a busbar connected to the battery cell, and transmits a detection signal to a battery management system (BMS) through a flexible printed circuit (FPC). To transmit the detected signal, a connector is connected to the flexible printing circuit.

### SUMMARY

The present disclosure relates to a rechargeable battery module that connects a flexible printing circuit (FPC) to a busbar. One or more embodiments provide a rechargeable battery module that transmits a detection signal for a battery cell to a battery management system (BMS) through short-distance wireless communication from a flexible printed circuit (FPC). One or more embodiments provides a rechargeable battery module that reduces or prevents increase in a height of the module even if a circuit element (chip fuse) is applied for short-distance wireless communication.

A rechargeable battery module according to one or more embodiments includes a busbar holder for covering battery cells, a busbar in the busbar holder for electrically connecting the battery cells, a flexible printed circuit in the busbar holder for transmitting a detection signal of a temperature or a voltage of one of the battery cells, a battery management system for receiving a transmission signal from a wireless communicator connected to the flexible printed circuit, and a printed circuit board on the flexible printed circuit for accommodating a circuit element on the flexible printed circuit for the wireless communicator.

The flexible printed circuit may include a single layer with a printed circuit pattern covered with a film.

The printed circuit board may include an upper printed circuit pattern on an upper surface, and a lower printed circuit pattern on a lower surface.

The upper printed circuit pattern and the lower printed circuit pattern may be respectively connected to a circuit pattern of the flexible printed circuit at an inside and an outside of a through-hole of the flexible printed circuit.

The circuit element may be connected to the circuit pattern of the flexible printed circuit inside the through-hole.

A first thickness of the printed circuit board may be greater than a height of the circuit element.

The circuit element may be covered with a coating liquid in the through-hole.

The flexible printed circuit may have a second thickness that is less than the first thickness.

The height of the circuit element may be greater than the second thickness, and that is less than the first thickness.

The flexible printed circuit may be attached to the busbar holder with an adhesive tape.

The rechargeable battery module may further include a top cover that covers the flexible printed circuit and the printed circuit board.

The top cover may be snap fit-coupled to the busbar holder.

The rechargeable battery module may further include a coating liquid in a through-hole, an additional flexible printed circuit on the coating liquid and the printed circuit board, and electrically connected to the printed circuit board, and an additional printed circuit board on the additional flexible printed circuit for accommodating an additional circuit element on the additional flexible printed circuit in the through-hole.

The additional flexible printed circuit may include a single layer of a printed circuit pattern covered with a film.

The additional printed circuit board may include an upper printed circuit pattern on an upper surface, and a lower printed circuit pattern on a lower surface.

The additional circuit element may be connected to the additional flexible printed circuit at an inside of the through-hole.

A first thickness of the additional printed circuit board may be greater than a height of the circuit element.

The additional circuit element may be covered with the coating liquid in the through-hole.

The additional circuit element may have a second height that is greater than a second thickness of the additional flexible printed circuit, and that is less than the first thickness.

The rechargeable battery module may further include a top cover covering the printed circuit board, wherein the flexible printed circuit defines an additional through-hole, wherein the printed circuit board defines a retreat groove corresponding to the additional through-hole, wherein the busbar holder defines a fastening hole corresponding to the additional through-hole, and wherein the top cover includes a protrusion fastened to the fastening hole via the retreat groove and the additional through-hole.

According to one or more embodiments, a detection signal of the battery cell is transmitted to the battery management system through short-distance wireless communication in a flexible printed circuit, thereby reducing quality issues and costs.

According to one or more embodiments, a circuit element (e.g., a chip fuse) is mounted on a flexible printed circuit, and is embedded in a through-hole of a separately provided printed circuit board, thereby reducing or preventing an increase in the height of the module.

### BRIEF DESCRIPTION OF THE DRAWINGS

FIG. 1 is a partial top plan view of a rechargeable battery module according to one or more first embodiments of the present disclosure.
FIG. 2 is a cross-sectional view of FIG. 1, taken along the line II-II.
FIG. 3 is a top plan view of portions of the printed circuit board (PCB) and the flexible printed circuit (FPC) of FIG. 1.
FIG. 4 is a cross-sectional view of FIG. 3, taken along the line IV-IV.
FIG. 5 is a partial top plan view of a rechargeable battery module according to one or more second embodiments of the present disclosure.
FIG. 6 is a cross-sectional view of FIG. 5, taken along the line VI-VI.
FIG. 7 is a partial top plan view of a rechargeable battery module according to one or more third embodiments of the present disclosure.
FIG. 8 is a cross-sectional view of FIG. 7, taken along the line VIII-VIII.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that the present disclosure covers all modifications, equivalents, and replacements within the idea and technical scope of the present disclosure, that each of the features of embodiments of the present disclosure may be combined with each other, in part or in whole, and technically various interlocking and operating are possible, and that each embodiment may be implemented independently of each other, or may be implemented together in an association, unless otherwise stated or implied.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

If overlap occurs in a circuit, a relatively expensive double layer flexible printed circuit (FPC) may be used, or a low-cost single layer flexible printed circuit (FPC) and a double-sided printed circuit board (PCB) may be used together, to solve the problem. The energy density of the rechargeable battery module may be increased, a connector connecting the flexible printed circuit (FPC) to a battery management system (BMS) may be removed, and short-distance wireless communication may be applied. Quality issues that may otherwise occur if connecting and separating connectors may be removed. A wireless communication multiplexer channel (CMC) may be provided between the flexible printing circuit (FPC) and the battery management system (BMS) to remove the connector.

A circuit element may be used depending on the use of the wireless CMC. As an example, the circuit element may be a chip fuse. Because the chip fuse protrudes onto a surface of the flexible printing circuit, the chip fuse may affect a height of the module, and may serve as an obstacle to lowering the height of the module.

If the chip fuse is applied, an adhesive tape may be used on a bottom end to protect the outside of the chip fuse, and a coating liquid, which hardens after application, may be applied to an upper portion of the chip fuse to reduce or prevent the likelihood of defects due to moisture. The coating liquid may also serve as an obstacle to lowering the height of the module.

If a height of a part of the busbar holder where the chip fuse is seated (e.g., about 3.94 mm) becomes higher than a height of a part where the busbar is seated (e.g., 3.6 mm), issues may arise.

If the chip fuse is applied, conformal coatings may be suitably applied, but due to the characteristics of the coating, height management may be difficult, and if the coating is not cured immediately after coating, the coating may flow, potentially causing the edge of the chip fuse to be exposed.

If a large amount of coating liquid is applied to reduce or prevent exposure of the edge of the chip fuse, a coating region may increase or extend to other parts, potentially causing the chip fuse position to disperse due to a lack of a space considering coating, and the entire process or process costs may increase.

A top cover made of a sheet, rather than an injection molded product, may be applied to the rechargeable battery module. A fastening structure of the top cover and a busbar holder may be applied as a snap fit structure.

If applying pressure to the top cover for this fastening, there is a possibility of pressing the chip fuse due to misidentification of the position. To reduce or prevent the likelihood of this happening, a protection structure for the chip fuse may be suitable.

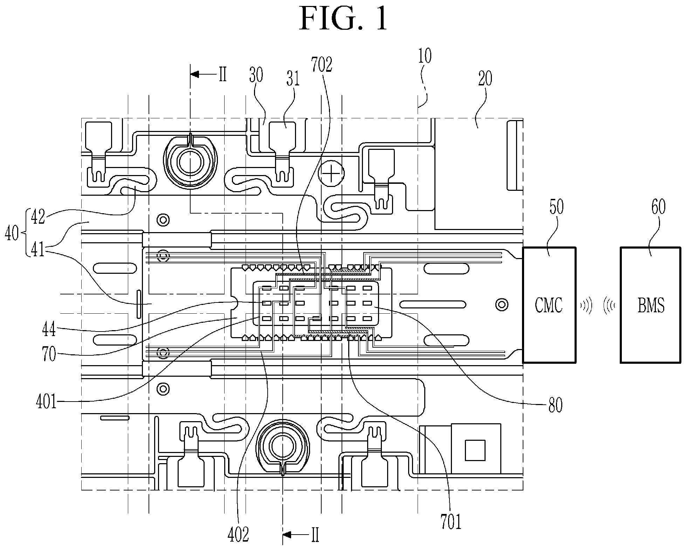

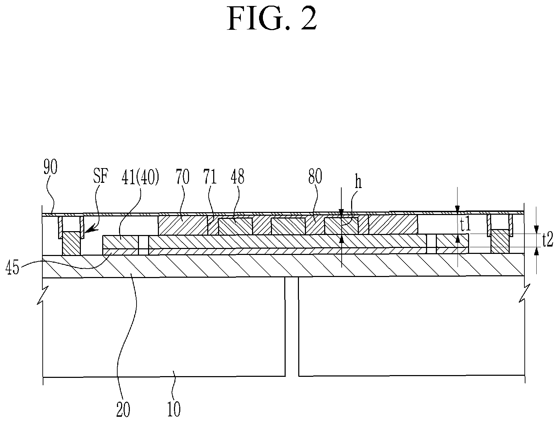

FIG. 1 is a partial top plan view of a rechargeable battery module according to one or more first embodiments of the present disclosure, and FIG. 2 is a cross-sectional view of FIG. 1, taken along the line II-II. Referring to FIG. 1 and FIG. 2, a rechargeable battery module 1 includes a busbar holder 20 covering a plurality of battery cells 10, busbar 30, a flexible printed circuit (FPC) 40, a wireless communicator 50, a battery management system (BMS) 60, and a printed circuit board (PCB) 70. As an example, the battery cells 10 are formed as a rechargeable battery.

The busbar holder 20 may be formed of an electrical-insulating material, may cover the plurality of battery cells 10, and may be configured to position the busbars 30 that electrically connect the battery cells 10. The busbars 30 may be placed on the busbar holder 20, and may electrically connect the battery cells 10 placed under the busbar holder 20.

The FPC 40 may be placed on the busbar holder 20, may detect the temperature and the voltage of the battery cell 10 through the busbars 30, and may transmit a detected signal to the BMS 60 through the wireless communicator 50. For detection of the temperature and the voltage, the flexible printing circuit 40 is connected to the busbar 30, for example with a tab 31.

The flexible printing circuit 40 includes a body portion 41 connected to the battery management system 60 through a wireless communicator 50, and a branch portion 42 extending from the body portion 41 to have a narrower width than the body portion 41. The branch portion 42 may be connected to the tab 31, and the tab 31 may be connected to the busbar 30 by laser welding.

The battery management system 60 may be arranged separately from the wireless communicator 50, and may be configured to receive a transmission signal from the wireless communicator 50 connected to the flexible printed circuit 40.

The printed circuit board 70 may provide an arrangement space for a plurality of circuit elements 44 mounted on the flexible printed circuit 40 for the wireless communicator 50. As a non-limiting example, the printed circuit board 70 has a through-hole 71. The circuit elements 44 are accommodated in the through-hole 71, and the printed circuit board 70 is placed on the flexible printed circuit 40 and fixed to the busbar holder 20.

The flexible printed circuit 40 may be formed as a single layer with a printed circuit pattern covered with film on both sides. The flexible printed circuit 40 may include a first circuit pattern 401 and a second circuit pattern 402 formed of a single layer. The single layer structure may lower the cost of the flexible printed circuit 40.

In this way, the double-sided printed circuit board 70 includes an upper printed circuit pattern 701 formed on an upper side, and a lower printed circuit pattern 702 formed on a lower side, to respectively correspond to the first and second circuit patterns 401 and 402 of the flexible printed circuit 40.

The double-sided printed circuit board 70 is provided in a portion of the flexible printed circuit 40 that suitably uses an overlap circuit pattern, and that is connected to the flexible printed circuit 40 in a circuit manner, thereby reducing or preventing an increase in the manufacturing cost of the flexible printed circuit 40.

For example, an area around circuit element 44 may suitably use circuit pattern overlap. The double-sided printed circuit board 70 may be used to connect the circuit element 44 located inside the through-hole 71 to the flexible printed circuit 40.

In the double-sided printed circuit board 70, the upper printed circuit pattern 701 and the lower printed circuit pattern 702 replace the printed circuit pattern of the flexible printed circuit 40 in areas where a circuit pattern overlap may be suitable. Using the through-hole 71 as a reference, the first circuit pattern 401 of the flexible printed circuit 40 is provided on the inside, and the second circuit pattern 402 of the flexible printed circuit 40 is provided on the outside.

If connecting the flexible printed circuit 40 and the double-sided printed circuit board 70, the upper printed circuit pattern 701 and the lower printed circuit pattern 702 are respectively connected to the first circuit pattern 401 and the second circuit pattern 402 of the flexible printed circuit 40 on the inside and outside of the through-hole 71.

A part of the circuit elements 44 is connected to the first circuit pattern 401 of the flexible printed circuit 40 through the upper printed circuit pattern 701, and the remaining part of the circuit elements 44 is connected to the second circuit pattern 402 through the lower printed circuit pattern 702.

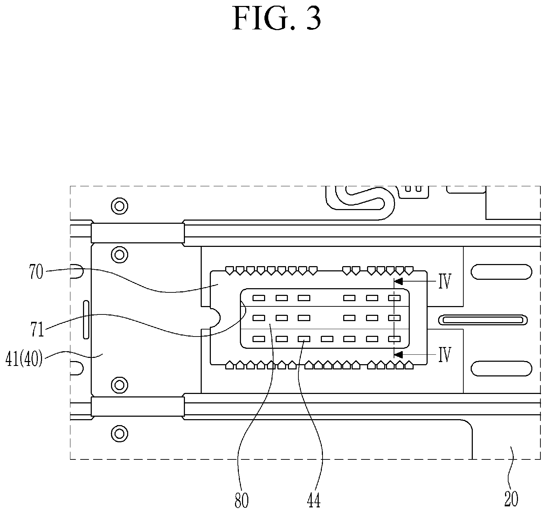

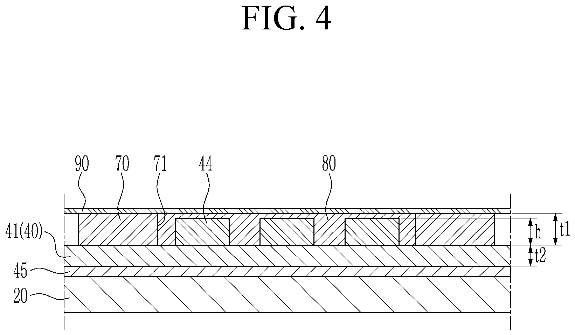

FIG. 3 is a top plan view of portions of the printed circuit board (PCB) and the flexible printed circuit (FPC) of FIG. 1, and FIG. 4 is a cross-sectional view of FIG. 3, taken along the line IV-IV. Referring to FIG. 2 to FIG. 4, a first thickness t1 of the printed circuit board 70 may be greater than a height h of the circuit element 44 (t1>h). The circuit element 44 may be covered with the coating liquid 80, which fills the through-hole 71. The coating liquid 80 may cover the side and top surface of the circuit element 44, and may fill the through-hole 71 up to the first thickness t1.

The problem of the edge of the circuit element 44 being exposed may be solved by securing an installation space for the circuit element 44 in the through-hole 71, and by filling the through-hole 71 with the coating liquid 80. Because the size of the through-hole 71 is preferably made constant, the process of applying the coating liquid 80 may be suitable, and the coating thickness may be consistent, thereby improving quality and reducing costs by simplifying the process.

The flexible printed circuit 40 may have a second thickness t2, which may be less than the first thickness t1 of the printed circuit board 70 (t2<t1). The circuit element 44 has a height h that is greater than the second thickness t2 (t2<h), and the height h may be less than the first thickness t1 (h<t1).

Despite having a greater height h than the second thickness t2 of the flexible printed circuit 40, the circuit element 44 can be protected by the first thickness t1 of the printed circuit board 70 and the coating liquid 80.

The flexible printed circuit 40 may be attached to the busbar holder 20 with an adhesive tape 45. The adhesive tape 45 may protect the circuit element 44 from impact or vibration. The circuit element 44 may be protected on the lower side by the adhesive tape 45, protected on the upper side by the coating liquid 80, and protected on the side by a printed circuit board 70.

The rechargeable battery module 1 of one or more embodiments may further include a top cover 90. The top cover 90 may cover the flexible printed circuit 40 and the printed circuit board 70. As an example, the top cover 90 is snap fit (SF)-coupled to the busbar holder 20.

If the top cover 90 is pressed, the printed circuit board 70 of the first thickness t1 supports the top cover 90, and the circuit element 44 with the height h within the through-hole 71 may be protected from the pressure of the top cover 90, and damage to the circuit element 44 can be reduced or prevented.

Hereinafter, various embodiments of the present disclosure will be described. Compared to the previously described embodiments, repeated descriptions of the same configuration may be omitted, and descriptions of different configurations are described.

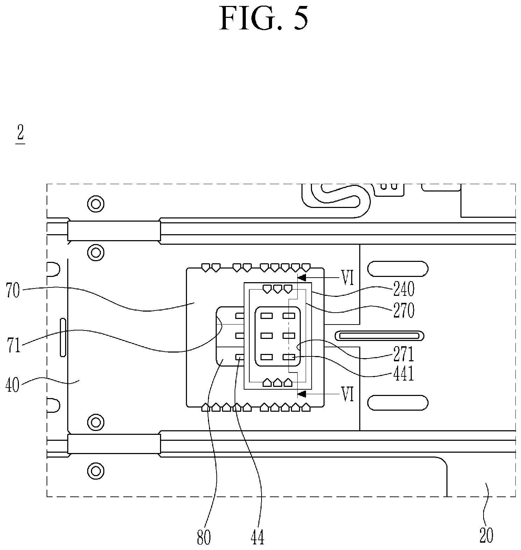

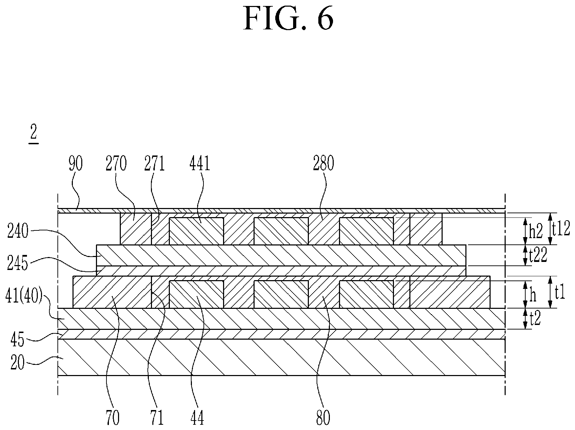

FIG. 5 is a partial top plan view of a rechargeable battery module according to one or more second embodiments of the present disclosure, and FIG. 6 is a cross-sectional view of FIG. 5, taken along the line VI-VI. Referring to FIG. 5 and FIG. 6, a rechargeable battery module 2 of the one or more second embodiments may include an additional flexible printed circuit 240 and an additional printed circuit board 270 in addition to the constituent element of the rechargeable battery module 1 of the one or more first embodiments.

In the one or more second embodiments, if an area where a circuit element 44 is to be installed is not sufficiently secured and a height is secured, the additional printed circuit board 270 may be placed on the second layer. The additional flexible printed circuit 240 may be formed as a single layer with a printed circuit pattern covered with a film on both sides.

The additional printed circuit board 270 may include an upper printed circuit pattern formed on an upper surface, and a lower printed circuit pattern formed on a lower surface. In one or more embodiments, the upper and lower circuit patterns may be formed in the same structure as the upper and lower printed circuit patterns 701 and 702 of the printed circuit board 270 of FIG. 1.

The additional flexible printed circuit 240 may be placed on a coating liquid 280 and on a printed circuit board 70, and may be electrically connected to the printed circuit board 70. The additional flexible printed circuit 240 may be attached to the coating liquid 280 and to the printed circuit board 70 via an adhesive tape 245.

The adhesive tape 245 may protect an additional circuit element 441 from impact or vibration. The additional circuit element 441 may be protected on a lower side by the adhesive tape 245, protected on an upper side by the coating liquid 280, and protected on the side by the additional printed circuit board 270.

The additional printed circuit board 270 may accommodate the circuit element 441 additionally mounted on the additional flexible printed circuit 240 in a through-hole 271, and may be located on the additional flexible printed circuit 240. The additionally mounted circuit element 441 may be connected to the printed circuit pattern of the additional flexible printed circuit 240 inside the through-hole 271.

A first thickness t12 of the additional printed circuit board 270 may be greater than a height (e.g., a second height) h2 of the additional circuit element 441 (t12 > h2). The additional circuit element 441 may be covered with the coating liquid 280 that is filled into the through-hole 271. The coating liquid 280 may coat a side surface and a top surface of the additional circuit element 441, and may be filled into the through-hole 271 up to the first thickness t12.

A problem of an edge of the additional circuit element 441 being exposed may be solved by securing an installation space for the additional circuit element 441 in the through-hole 271, and by filling the installation space with the coating liquid 280. Because the size of the through-hole 271 is constant, the application process of the coating liquid 280 may be achieved, and the coating thickness may be constant, thereby improving quality and reducing costs by simplifying the process.

The additional flexible printed circuit 240 may have a second thickness t22 that is less than the first thickness t12 of the additional printed circuit board 270 (t22 < t12). The additional circuit element 441 may have a height h2 that is greater than the second thickness t22 (t22 < h2) and that is less than the first thickness t12 (h2 < t12).

Although the additional circuit element 441 has a height h2 that is greater than the second thickness t22 of the additional flexible printed circuit 240, the additional circuit element 441 can be protected by the first thickness t12 of the additional printed circuit board 270 and the coating liquid 280.

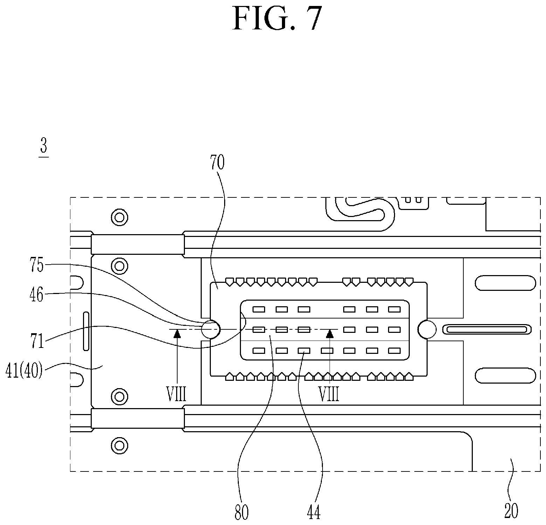

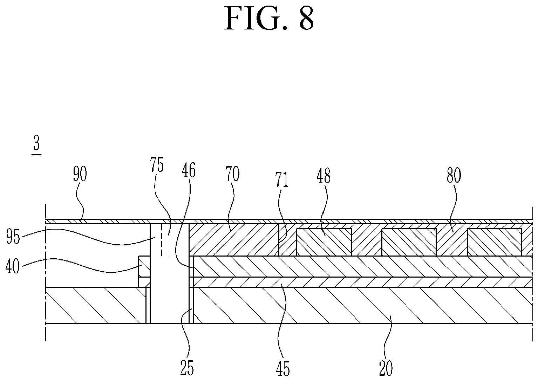

FIG. 7 is a partial top plan view of a rechargeable battery module according to one or more third embodiments of the present disclosure, and FIG. 8 is a cross-sectional view of FIG. 7, taken along the line VIII-VIII. Referring to FIG. 7 and FIG. 8, a rechargeable battery module 3 of the one or more third embodiments includes the flexible printed circuit 40 of the rechargeable battery module 1 of the one or more first embodiments, which is provided with a through-hole 46, a printed circuit board 70 provided with a retreat groove 75 corresponding to the through-hole 46, and a busbar holder 20 provided with a fastening hole 25 corresponding to the through-hole 46.

A top cover 90 is provided with a protrusion 95. If the printed circuit board 70 is covered with the top cover 90, the protrusion 95 may be fastened to the fastening hole 25 via the retreat groove 75 and the through-hole 46. The protrusion 95, the retreat groove 75, the through-hole 46, and the fastening hole 25 may increase the degree of freedom in the design to connect the top cover 90 to the busbar holder 20.

Although one or more embodiments of the present disclosure have been described in detail above, the scope of the present disclosure is not limited thereto, and various modifications and improvements of those skilled in the art using the basic concept of the present disclosure defined in the following claims also belong to the scope of the present disclosure, with functional equivalents of the claims to be included therein.

### Description of Some of the Reference Characters

| | | | |
|---|---|---|---|
| 1, 2, 3: | rechargeable battery module | 25: | fastening hole |
| 10: | battery cell | 20: | busbar holder |
| 30: | busbar | 31: | tab |
| 40, 240: | flexible printed circuit (FPC) | 41: | body portion |
| 42: | branch portion | 44, 441: | circuit element |
| 45, 245: | adhesive tape | 46: | through-hole |
| 50: | wireless communicator | 60: | battery management system (BMS) |
| 70, 270: | printed circuit board (PCB) | 71, 271: | through-hole |
| 75: | retreat groove | 80, 280: | coating liquid |
| 90: | top cover | 95: | protrusion |
| 401: | first circuit pattern | 402: | second circuit pattern |
| 701: | upper printed circuit pattern | 702: | lower printed circuit pattern |
| h, h2: | height | t1, t12: | first thickness |
| t2, t22: | second thickness | | |

## Claims

1. A rechargeable battery module (1, 2, 3) comprising:
a busbar holder (20) for covering battery cells (10);
a busbar (30) in the busbar holder (20) for electrically connecting the battery cells (10);
a flexible printed circuit (40, 240) in the busbar holder (20) for transmitting a detection signal of a temperature or a voltage of one of the battery cells (10);
a battery management system (60) for receiving a transmission signal from a wireless communicator (50) connected to the flexible printed circuit; and
a printed circuit board (70, 270) on the flexible printed circuit (40, 240) for accommodating a circuit element (44, 441) on the flexible printed circuit (40, 240) for the wireless communicator (50).

2. The rechargeable battery module (1, 2, 3) of claim 1, wherein the flexible printed circuit (40, 240) comprises a single layer with a printed circuit pattern covered with a film.

3. The rechargeable battery module (1, 2, 3) as claimed in claim 1, wherein the printed circuit board (70, 270) comprises an upper printed circuit pattern (701) on an upper surface, and a lower printed circuit pattern (702) on a lower surface.

4. The rechargeable battery module (1, 2, 3) as claimed in claim 3, wherein the upper printed circuit pattern (701) and the lower printed circuit pattern (702) are respectively connected to a circuit pattern of the flexible printed circuit (40, 240) at an inside and an outside of a through-hole (46, 71, 271) of the flexible printed circuit.

5. The rechargeable battery module (1, 2, 3) as claimed in claim 4, wherein the circuit element (44, 441) is connected to the circuit pattern of the flexible printed circuit (40, 240) inside the through-hole (46, 71, 271).

6. The rechargeable battery module (1, 2, 3) as claimed in claim 5, wherein a first thickness (t1, t12) of the printed circuit board (70, 270) is greater than a height (h) of the circuit element (44, 441).

7. The rechargeable battery module (1, 2, 3) as claimed in claims 1 to 6, wherein the flexible printed circuit (40, 240) is attached to the busbar holder (20) with an adhesive tape (45, 245).

8. The rechargeable battery module (1, 2, 3) as claimed in claims 1 to 7, further comprising a top cover that covers the flexible printed circuit (40, 240) and the printed circuit board (70, 270) and/or wherein the top cover is snap fit-coupled to the busbar holder (20).

9. The rechargeable battery module (1, 2, 3) as claimed in claims 1 to 8, further comprising:
a coating liquid (80, 280) in a through-hole (46, 71, 271);
an additional flexible printed circuit (40, 240) on the coating liquid (80, 280) and the printed circuit board (70, 270), and electrically connected to the printed circuit board (70, 270); and
an additional printed circuit board (70, 270) on the additional flexible printed circuit (40, 240) for accommodating an additional circuit element (44, 441) on the additional flexible printed circuit (40, 240) in the through-hole (46, 71, 271).

10. The rechargeable battery module (1, 2, 3) as claimed in claim 9, wherein the additional flexible printed circuit (40, 240) comprises a single layer of a printed circuit pattern covered with a film.

11. The rechargeable battery module (1, 2, 3) as claimed in claim 9, wherein the additional printed circuit board (70, 270) comprises an upper printed circuit pattern (701) on an upper surface, and a lower printed circuit pattern (702) on a lower surface.

12. The rechargeable battery module (1, 2, 3) as claimed in claim 9, wherein the additional circuit element (44, 441) is connected to the additional flexible printed circuit (40, 240) at an inside of the through-hole (46, 71, 271).

13. The rechargeable battery module (1, 2, 3) as claimed in claim 12, wherein a first thickness (t1, t12) of the additional printed circuit board (70, 270) is greater than a height (h) of the circuit element (44, 441).

14. The rechargeable battery module (1, 2, 3) as claimed in claim 13, wherein the additional circuit element (44, 441) is covered with the coating liquid (80, 280) in the through-hole (46, 71, 271) and/or wherein the additional circuit element (44, 441) has a second height (h2) that is greater than a second thickness (t2, t22) of the additional flexible printed circuit (40, 240), and that is less than the first thickness (t1, t12).

15. The rechargeable battery module (1, 2, 3) as claimed in claim 9, further comprising a top cover covering the printed circuit board (70, 270),
wherein the flexible printed circuit (40, 240) defines an additional through-hole (46, 71, 271),
wherein the printed circuit board (70, 270) defines a retreat groove (75) corresponding to the additional through-hole (46, 71, 271),
wherein the busbar holder (20) defines a fastening hole (25) corresponding to the additional through-hole (46, 71, 271), and
wherein the top cover comprises a protrusion (95) fastened to the fastening hole (25) via the retreat groove (75) and the additional through-hole (46, 71, 271).
